# EUROPEAN PATENT SPECIFICATION

(11) **EP 0 559 982 B1**
(45) Date of publication and mention of the grant of the patent: **26.05.1999**
(21) Application number: 92308888.4
(22) Date of filing: 30.09.1992
(51) Int. Cl.: H04N 7/24, H04N 5/91

(54) **Image compression**
Bildkompression
Compression d'images

(30) Priority: 13.03.1992 US 851019
(43) Date of publication of application: 15.09.1993
(73) Proprietor: SAMSUNG ELECTRONICS CO. LTD., Suwon-city, Kyounggi-do 441-742 (KR)
(72) Inventor: Kim, Yong-kyu, Kangnam-ku, Seoul (KR); Tianmin,Liu, Lawrenceville, NJ 08648 (US); Strolle, Christopher H., Glenside, Pennsylvania 19038 (US); Jaffe, Steven Todd, Freehold, NJ 07728 (US)
(74) Representative: Stanley, David William

(56) References cited:
- US-A- 5 086 439
- SIGNAL PROCESSING III: THEORIES AND APPLICATIONS, 1986, NL pages 789 - 792 GÖTZE ET AL 'ADAPTIVE TRANSFORM CODING OF IMAGES USING VECTOR QUANTIZATION'
- TWENTY-FOURTH ASILOMAR CONFERENCE ON SIGNALS, SYSTEMS & COMPUTERS, November 1990, PACIFIC GROVE, CA., US pages 336 - 340, XP000280042 WU ET AL 'Optimal Block-Adaptive Image Coding with Constrained Bit-Rate'
- TWENTY-FIFTH ASILOMAR CONFERENCE ON SIGNALS, SYSTEMS & COMPUTERS, November 1991, PACIFIC GROVE, CA., US pages 1133 - 1137, XP000280042 GONG ET AL 'Progressive Image Transmission Using Self-supervised Backpropagation Neural Network'
- SIGNAL PROCESSING. IMAGE COMMUNICATION, vol.3, no.4, September 1991, AMSTERDAM NL pages 321 - 331, XP000234973 TANAKA ET AL 'Bit-rate control algorithm on video packet coding and its characteristics'
- SIGNAL PROCESSING. IMAGE COMMUNICATION, vol.3, no.2/3, June 1991, AMSTERDAM NL pages 275 - 283, XP000234969 EFRATI ET AL 'Classified block truncation coding-vector quantization : An edge sensitive image compression algorithm'

## Description

The present invention relates to image compression.

Recently, video information compressing technology has been used in processing a video signal as digital data in a digital video apparatus such as a digital VCR (video cassette recorder), HDTV (high-definition television), a digital video camera or a video phone.

Since known image compression technology has a variable number of compressed coding bits according to picture complexity, a problem has been raised about how to keep constant a compression result in digital VCRs, HDTVs and others which require a constant compression result. Especially, for a characteristic of image compression method for a digital VCR, since its recording medium is magnetic tape which enables only sequential recording and playback, the above image compression method for a digital VCR has more limitations than that of an ordinary transmission line or disk (CD or hard disk). The most serious problem to be solved is a special playback function (also known as "trick play") such as a high speed search.

For a solution, when an image compression method and its tape format are selected, movement of the VCR head (the head's scanning trace) during recording and playback should be considered. In other words, for special functions such as a high speed search, during compression, each image should be exactly the same size, and a portion of data on a tape should correspond to the image's original screen position and be reproduced regardless of other images.

Generally, however, during coding, a complicated portion of an image requires a relatively large amount of bits and a simple portion relatively few bits. Accordingly, when video signals corresponding to one picture or one segment thereof are to be encoded and recorded in a track having a limited length of magnetic tape, and if the number of encoded bits exceeds one track, a conventional digital VCR method records the excess encoded bits in a next track or, if the number of encoded bits reaches the number of set bits, stops coding the remaining part which is discarded.

However, the recording method of the excess encoded bits in a next track has difficulty in a special playback or high speed search, and the coding stop method deteriorates the quality of a reproduced picture because of partial loss of its picture information.

An aim of preferred embodiments of the present invention is to provide an image compression decoding method and apparatus therefor which records, on magnetic tape, codes produced by a multilevel compression method which more compactly compresses lower levels of an image to output a result having a constant number of bits and outputs an encoded result having components leading to a more elaborate picture in higher levels, and decodes only the lower level codes in a special playback mode such as a high speed search differently from a normal playback mode where the entire code is decoded, thereby enabling a special playback function.

To accomplish such aims, in certain embodiments of image compression encoding and decoding method and apparatus of the present invention, DC coefficients of a DCT block are scalar-quantized and AC coefficients are classified-vector-quantized (CVQ). Respective DCT blocks are classified by the least value of the square of the result that part of or all the AC coefficients among horizontal AC coefficients including a first AC coefficient according to a zigzag scanning sequence of a DCT block, and vertical AC coefficients including a second AC coefficient, are subtracted from a representative value of a preset reference class. Using a multilevel compression method, lowest level codes are vector-partitioned by P-units at equal intervals with respect to each classified DCT block, and code books of representative vectors corresponding to the partitioned vectors are provided. Indices of corresponding representative vectors in respective code books and the classified codes are provided as encoding data corresponding to AC coefficients to keep a constant number of bits. Then, errors created in a preceding level are obtained. Code books of S-units of representative vectors corresponding to the errors are provided again. The multilevel CVQ of the method providing corresponding indices and parity data in the respective code books is performed to be encoded. Here, codes are output in which an image is more compactly compressed in lower levels, and higher levels have a more elaborate picture. Decoding is performed in the reverse sequence of encoding. During a high speed search, only the lowest level codes having a constant number of bits are restored regardless of the complexity of the picture so that a high speed search does not lead to deterioration of picture quality.

According to an aspect of the present invention, there is provided a compression encoding method for partitioning a two-dimensional video signal into DCT blocks and encoding a transform coefficient of each DCT block at a predetermined compression rate, said method comprising:
scalar-quantizing the DC coefficient of each DCT block by n bits:
a lowest level vector quantization step of classifying AC coefficients of each DCT block into m classes, comparing the classified AC coefficients of each DCT block to f representative vectors from a code book set for each class, selecting a respective representative vector with the smaller error, vector-quantizing the selected representative vector with a g-bit index of each representative vector, and generating a number of encoding bits (B) for every block at a predetermined bit rate according to the equation B = n + log₂ m + f·g;
a repeating multilevel vector quantization step of comparing the difference between the vector quantization result from a preceding quantization step and all the AC coefficients of said each DCT block, that is, errors produced from the preceding quantization step, to h representative vectors from respective code books set for each classified class, selecting respective representative vectors with the smallest error and vector-quantizing the representative vectors with a g-bit index of each representative vector; and
an intra-frame vector allocation step of determining an encoding parameter whereby if the number of required bits for the preceding frame is smaller than that of the reference bits set for one frame, the value of the encoding parameter is controlled to require a larger number of bits in encoding a current image, and if the number of required bits for the preceding frame is larger than that of the reference bits set for one frame, the value of the encoding parameter is controlled to require a smaller number of bits in encoding a current image and adaptively allocating vectors having an activity above the encoding parameter among the vectors output from said repeating multi level vector quantization step.

Preferably, in said classification using part of or all the AC coefficients among horizontal AC coefficients including a first AC coefficient and vertical AC coefficients including a second AC coefficient according to a zigzag scanning sequence of said each DCT block, edge direction is detected according to the least value of the square of the value in which the AC coefficients are subtracted from representative values for preset reference classes, and according to the detected results, each DCT block is classified.

Preferably, in said lowest level quantization and repeating multilevel quantization steps, vectors are partitioned by equal interval sampling.

Preferably, in said lowest level vector quantization step, vectors are partitioned by three equal interval samplings, and in said repeating multilevel quantization step, vectors are partitioned by nine equal interval samplings.

Preferably, in said lowest level vector quantization step, variables n, m, p, and g have 8, 8, 3, and 7 bits, respectively, so that the overall number of bits is 32 for every block.

Preferably, in said lowest level quantization and repeating multilevel quantization steps, all the representative vectors are sorted according to their statistical values selected from activity and dispersion value, and the vector search area is set within a certain region according to an activity or dispersion value of input vectors so as to reduce calculation time.

Preferably, in said intra-frame vector allocation step, considering its activity, said encoding parameter is determined by a comparison result of the reference bits with the encoding result of the video signal of a preceding image.

Preferably, in said intra-vector allocation step, the reference bits are satisfied by being differentially encoded according to weights and by image sections.

Preferably, a sync block is provided which comprises a sync signal for indicating the beginning and end of said sync block, an index signal for indicating a position within a frame, a first level quantization encoding code contained in an independent decodable code IDC area, an error correction code (ECC) for error-correcting the code loaded on the IDC area, a plurality of multilevel vector quantization encoding codes contained in a dependent decodable code (DDC) area, and an error correction code (ECC) for error-correcting the code loaded on the DDC area.

According to a further aspect of the present invention, there is provided a compression encoder for partitioning a two-dimensional video signal into DCT blocks and encoding a transform coefficient of each DCT block at a predetermined compression rate, the encoder comprising:
DC encoding means for scalar-quantizing the DC coefficient of said each DCT block;
classifier means for classifying AC coefficients of said each DCT block into m classes;
lowest level quantization means for comparing the classified AC coefficients of said each DCT block to f representative vectors from a code book set for each class classified by said classifier means selecting a respective representative vector with the smallest error, and vector-quantizing the selected representative vector with a g-bit index of each representative vector;
a plurality of multilevel vector quantization means for comparing the difference between the representative vector value from a preceding level vector quantization means and all the AC coefficients of said each DCT block, that is, errors produced from a preceding level encoding step, to h representative vectors from respective code books set for each classified class, selecting respective representative vectors with the smallest error and vector-quantizing the representative vectors with a g-bit index of each representative vector; and
intra-frame vector allocation means for determining an encoding parameter whereby if the number of required bits for the preceding frame is smaller than that of the reference bits set for one frame, the value of the encoding parameter is controlled to require a larger number of bits in encoding a current image, and if the number of required bits for the preceding frame is larger than that of the reference bits set for one frame, the value of the encoding parameter is controlled to require a smaller number of bits in encoding a current image, and adaptively allocating vectors having an activity above the encoding parameter among the vectors of said plurality of multilevel vector quantization means.

For a better understanding of the invention, and to show how the same may be carried into effect, reference will now be made, by way of example, to the accompanying diagrammatic drawings, in which:
Figure 1 is a block diagram of one example of a video compression coder according to the present invention;
Figure 2 illustrates DC and AC coefficients of an 8 by 8 DCT block;
Figure 3 illustrates a classification in a classifier of the video compression coder of Figure 1;
Figures 4A and 4B illustrate a tape format for the video compression coder of Figure 1; and
Figure 5 is a block diagram of one example of a video compression decoder according to the present invention.

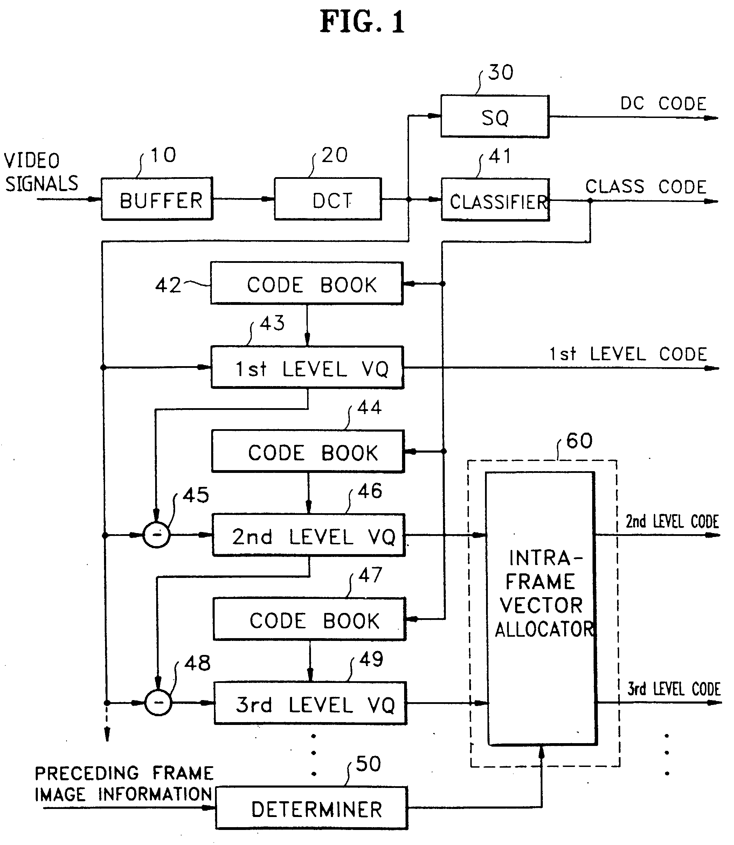

In Figure 1, Y, R-Y, and B-Y video signals (4:2:2) input from a signal input source are subsampled with respect to a chrominance difference signal by a buffer 10 to be changed into 4:2:0 form. Here, a 4:2:2 form represents Y (width: 720 pixels; length: 480 pixels), and R-Y and B-Y (width: 360 pixels; length: 480 pixels) for one picture, while a 4:2:0 form represents Y (width: 720 pixels, length: 480 pixels), and R-Y and B-Y (width: 360 pixels, length: 240 pixels) for one picture.

A DCT block 20 divides the two-dimensional video signal output from buffer 10 into N by N blocks (e.g. 8 by 8) and DCT-transforms each block to generate DCT coefficients. A DC encoder 30 scalar-quantizes (SQ) the DC values of DCT block 20 by eight bits and, for decoding, records them on tape.

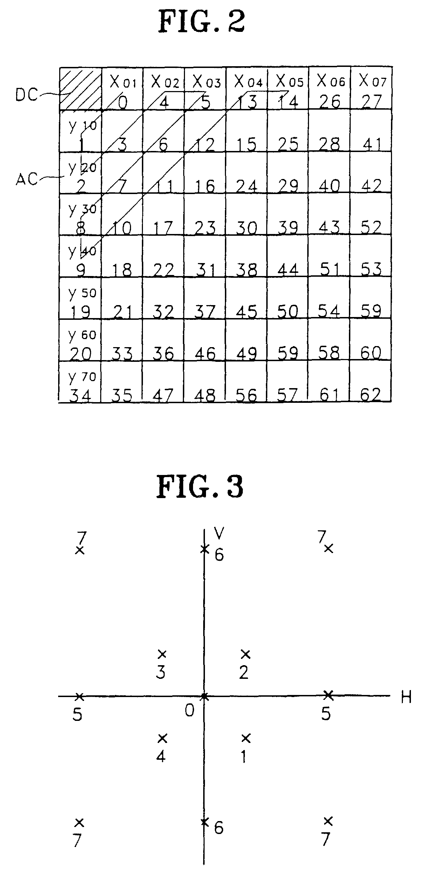

A classifier 41 selects part of or all the AC coefficients (k) (here, x01 and y01) among horizontal AC coefficients including a first AC coefficient according to the zigzag scanning sequence of a DCT block and vertical AC coefficients including a second AC coefficient. As shown in Figure 3, edge direction is detected according to the minimum value of the square of the value from which are subtracted representative values Yj of eight reference classes preset in the horizontal, vertical, diagonal and opposing diagonal directions. According to the detected results, each DCT block is classified into eight classes. In other words,
class = C, Yc ∈ min dis(Yj,X) (O≤j≤7)

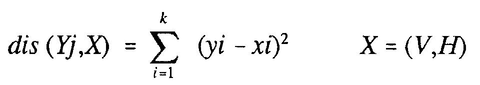

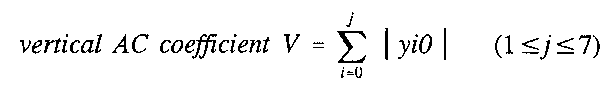

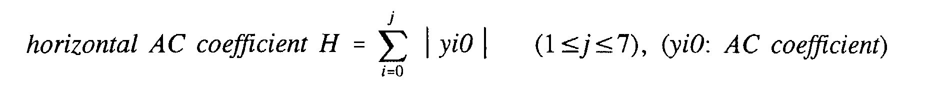

In other words, each DCT block is classified into a most approximate class by the V and H values on the coordinates of Figure 3. Here, value j is more favorable as it becomes larger but may be selected according to the complexity of classifier 41. For decoding, these class codes are recorded on tape by three bits.

A first code book 42 contains 21 components and 128 vectors according to each class. A clustering algorithm (LBG algorithm) is used with respect to a transform coefficient relating to an edge characteristic, among DCT coefficients. Such an LBG algorithm is disclosed in "An Algorithm for Vector Quantizer Design" (Y. Linde, A. Buzo and R. M. Gray, IEEE Trans. on Comm., vol. COM-28, pp. 84-95, Jan. 1980).

A first level vector quantization block 43 selects a code vector having the smallest error by comparing DCT input vectors with vectors of the code book, and outputs addresses that are indices of the vector as 7-bit compressed codes. In other words, the input DCT blocks are vector-partitioned by equal interval sampling to form three vectors. That is, as shown in Figure 2, an 8-by-8 DCT block is zigzag-scanned and one-dimensionally arranged as follows.$\text{VECTOR 0 = (0, 3, 6, 9, 12, 15, 18, 21, 24, 27, 30, 33, 36, 39, 42, 45, 48, 51, 54, 57, 60)}$$\text{VECTOR 1 = (1, 4, 7, 10, 13, 16, 19, 22, 25, 31, 34, 37, 40, 43, 46, 49, 52, 55, 58, 61)}$$\text{VECTOR 2 = (2, 5, 8, 11, 14, 17, 20, 23, 26, 32, 35, 38, 41, 44, 47, 50, 53, 56, 59, 62)}$

This is based upon "Asymptotic Performance of Block Quantizers with Difference Distortion Measure" (Y. Yamada, S. Tazaki and R. M. Gray, IEEE Trans. inform. Theory, Vol.IT-26, pp.6-14, Jan. 1980). Here, the reason the vectors are partitioned is to reduce the distortion of vector quantization. The whole distortion is as follows.${\text{D1 = K(k)N}}^{\text{-2/k}} {\text{σ}}^{\text{2}}$${\text{σ}}^{\text{2}} {\text{= [det p]}}^{\text{1/k}} {\text{= σg}}^{\text{2}} {\text{= π (σi}}^{\text{2}} {\text{)}}^{\text{1/k}}$ Here, K(k) is a constant, [det P] is a correlation determinant, and N is a uniform probability in the case of DC or a Laplacian probability in the case of AC.

In the above equations, as value σ² becomes smaller, value D1 (distortion) becomes smaller. Therefore, in order to reduce the value of geometric dispersion σg², the vector is partitioned because, when the values of the vector consist of both low-frequency components and high-frequency components of the DCT block, the value σg² becomes smaller. The illustrated embodiment of the present invention is composed of three vectors to improve picture quality by about 2dB.

When a code vector having little error is selected, all 128 vectors are usually compared, which requires a considerable amount of operation. Thus, here, in order to reduce the amount of operation, all the vectors of code books 42, 44, and 47 are sorted according to a mathematic statistical value such as an activity or dispersion value. In other words, by obtaining the mathematic statistical value such as an input vector activity or a dispersion value, the search area of the code books is reduced to one quarter of their original search area according to the obtained mathematic statistical value so as to also reduce the amount of operation to one quarter.

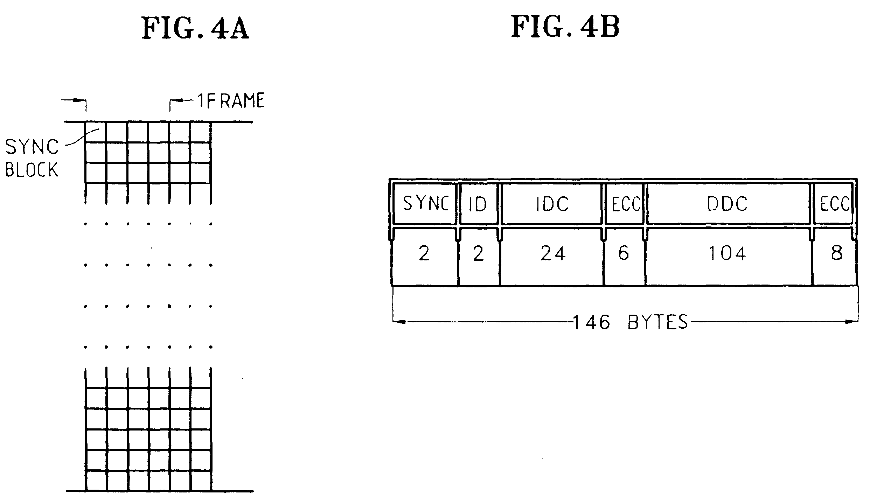

A first level code, which is the output of a first level vector quantization block 43, is compressed to 1/16. During special playback such as a high speed search, only the first level code is reproduced. During normal playback, the first level code is reproduced along with a higher level code. Even with only the first level code being reproduced, the image can be obtained. When recorded on tape, as shown in Figure 4, the first level code is recorded at equal intervals on an independent decodable code (IDC) region. The code for tape-recording has a total of 21 bits where each vector has seven bits, and decoding requires at least 32 bits (8 DC bits + 3 class bits + 21 vector bits).

Second and third code books 44 and 47 each have seven components and 128 vectors. A first subtracter 45 subtracts an encoding result in first level vector quantization block 43, that is, the vectors of first code book 42 corresponding to selected indices, from all the AC coefficients of DCT block 20 and excluding its DC coefficients, and encodes errors produced during the lowest level encoding.

A second level vector quantization block 46 vector-partitions the input DCT block by equal interval sampling to form nine vectors. A second subtracter 48 subtracts an encoding result in second level vector quantization block 46, from all the AC coefficients from DCT block 20 and excluding its DC coefficients, and encodes errors produced during the second level encoding in third level vector quantization block 49. In other words, an image cannot be reproduced with only the second and third level vector codes. The second and third level vector codes should be necessarily reproduced along with the lowest level code to obtain an image.

Meanwhile, a parameter determiner 50 determines an encoding parameter of the image of a current picture, based upon an encoding result of the video signal of a preceding picture. As the encoding result of a preceding image, if the number of required bits is smaller than that of the reference bits set for one frame, the value of the parameter is controlled to require a larger number of bits in encoding a current image, and if the number of required bits is larger than that of the reference bits set for one frame, the value of the parameter is controlled to require a smaller number of bits in encoding a current image. Here, a data transmission speed M of digital VCR is 20 megabits per second (Mbps). As one second needs 30 frames, a number b (reference bits for one frame) is M/30. In other words, if the difference between the number of required bits and reference bits is larger than a preset value, the parameter is determined while considering the reference bit number using the vector distribution according to its activity.

An intra-frame vector allocator 60 adaptively allocates vectors by the parameter determined by parameter determiner 50.

Even if the number of vectors to be encoded in second and third level vector quantization blocks 46 and 49 is eighteen, since only about nine vectors are allowed to be encoded considering the number of reference bits, only vectors having an activity above a proper size (threshold value) in view of the activity are actually encoded. The activity of each vector is defined as follows.

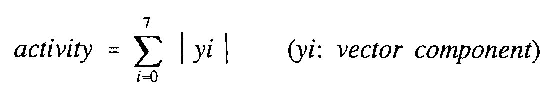

Here, the threshold value (THR) is determined by the encoding state of a preceding image, that is to say, the transfer vectors from second and third level vector quantization blocks 46 and 49, are represented as follows.$\text{transfer vector = Vj, (j ∈ actj 〉 THR), (0≤j≤8)}$

Though the number of bits of the second and third level encoding codes is fixed for one frame, they can be varied in units of a sync block. In other words, as shown in Figure 4A, one frame has four tracks and here one sync block has six DCT blocks. Each sync block comprises a sync signal for indicating its beginning and end, an index signal for indicating its position in a frame, a first level quantization encoding code contained in an IDC area, an error correction code (ECC) for error-correcting the code loaded on the IDC area, a plurality of vector quantization encoding codes contained in a dependent decodable code (DDC) area, and an ECC for error-correcting the code loaded on the DDC area.

If the required number of bits exceeds the number of reference bits, the amount of bits in the periphery of the image is forced to be reduced. The image on the periphery is reproduced using only the lowest level code. This means that the center and the periphery of an image are encoded using different weights. This is possible because normal human vision will concentrate mainly on the center of an image.

Higher level codes are sequentially recorded on the DDC area shown in Figure 4B when recorded on tape. The second level needs 9-bit parity data and the third level needs parity data having the number of bits equaling the number of actual transfer vectors for the second level. The parity data indicates to a decoder which vector is actually recorded on a tape.

Here, without intra-frame vector allocator 60, the reference bits are satisfied by only using differential encoding according to weights and by image sections. Good picture quality can be obtained even if the image is divided into a plurality of levels from its center to its periphery, so that the lowest level is uniformly encoded and higher levels are encoded by varying their parameters for each level.

From here on, an example of an image compression decoding method according to the present invention will be briefly described. In essence, the decoding method is performed by the reverse order of the image compression coding method.

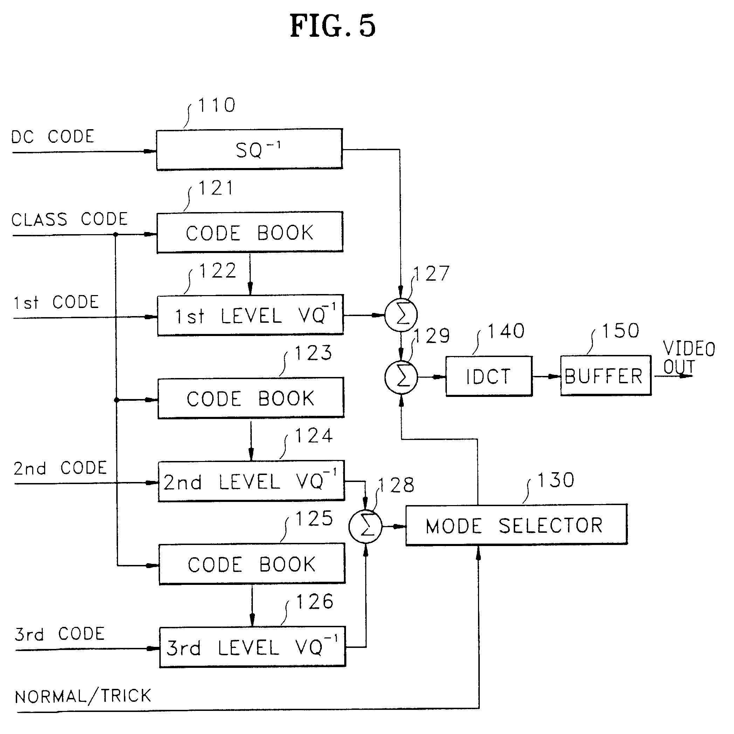

In Figure 5, a DC decoder 110 inverse-scalar-quantizes an input 8-bit DC code reproduced from a tape, and decodes it as DC coefficients. A first code book 121, which is the same as code book 42 of Figure 1, has 21 components and 128 vectors. Second and third code books 123 and 125, which are the same as code books 44 and 47 of Figure 1, each have 7 components and 128 vectors. Each code book 121, 123 and 125 outputs its vector according to an input class code.

A first level vector inverse-quantization block 122 outputs a corresponding vector component by comparing an input first level code and the code of code book 121. The decoding result of the first level code as well as the DC coefficients are supplied to a first adder 127. Second and third level vector inverse-quantization blocks 124 and 126 output a corresponding vector component by the comparison of second and third level codes loaded on the DDC area with the codes of code books 123 and 125. The decoding results of the second and third level codes are supplied to a second adder 128.

Meanwhile, according to a normal/trick playback control signal for indicating whether a VCR is in a normal playback or special playback mode, a mode selector 130 supplies the outputs of second and third level vector inverse-quantization blocks 124 and 126 to a third adder 129, during normal playback. During a trick playback such as high speed search, since only the lowest level code is reproduced according to the VCR characteristic and the higher level codes are not reproduced, mode selector 130 supplies a null signal to third adder 129.

Third adder 129 adds the DC and the decoding results of the respective levels, and an inverse-DCT block 140 inverse-DCT-transforms the added outputs to be converted into an original two-dimensional video signal. A buffer 150 changes the inverse-DCT result into an appropriate output form, that is, changes a 4:2:0 form into a 4:2:2 form.

The image compression encoding and decoding method and apparatus described above compresses DCT blocks by steps, using classified vector quantization via a multilevel compression method so that, during a special playback mode such as high speed search, only the lowest level image having a fixed number of bits is reproduced, thereby causing no degradation of picture quality during the special playback mode.

## Claims

1. A compression encoding method for partitioning a two-dimensional video signal into DCT blocks and encoding a transform coefficient of each DCT block at a predetermined compression rate, said method comprising:
scalar-quantizing the DC coefficient of each DCT block by n bits;
a lowest level vector quantization step of classifying AC coefficients of each DCT block into m classes, comparing the classified AC coefficients of each DCT block to f representative vectors from a code book set for each class, selecting a respective representative vector with the smallest error, vector-quantizing the selected representative error, with a g-bit index of each representative vector, and generating a number of encoding bits (B) for every block at a predetermined bit rate according to the equation B = n + log₂ m + f·g;
a repeating multilevel vector quantization step of comparing the difference between the vector quantization result from a preceding quantization step and all the AC coefficients of said each DCT block, that is, errors produced from the preceding quantization step, to h representative vectors from respective code books set for each classified class, selecting respective representative vectors with the smallest error and vector-quantizing the representative vectors with a g-bit index of each representative vector; and
an intra-frame vector allocation step of determining an encoding parameter whereby if the number of required bits for the preceding frame is smaller than that of the reference bits set for one frame, the value of the encoding parameter is controlled to require a larger number of bits in encoding a current image, and if the number of required bits for the preceding frame is larger than that of the reference bits set for one frame, the value of the encoding parameter is controlled to require a smaller number of bits in encoding a current image and adaptively allocating vectors having an activity above the encoding parameter among the vectors output from said repeating vector multi level quantization step.

2. An image compression encoding method as claimed in claim 1, wherein, in said classification using part of or all the AC coefficients among horizontal AC coefficients including a first AC coefficient and vertical AC coefficients including a second AC coefficient according to a zigzag scanning sequence of said each DCT block, edge direction is detected according to the least value of the square of the value in which the AC coefficients are subtracted from representative values for preset reference classes, and according to the detected results, each DCT block is classified.

3. An image compression encoding method as claimed in claim 1 or 2, wherein, in said lowest level quantization and repeating multilevel quantization steps, vectors are partitioned by equal interval sampling.

4. An image compression encoding method as claimed in claim 3, wherein, in said lowest level vector quantization step, vectors are partitioned by three equal interval samplings, and in said repeating multilevel quantization step, vectors are partitioned by nine equal interval samplings.

5. An image compression encoding method as claimed in any of the preceding claims, wherein, in said lowest level vector quantization step, variables n, m, p, and g have 8, 8, 3, and 7 bits, respectively, so that the overall number of bits is 32 for every block.

6. An image compression encoding method as claimed in any of the preceding claims, wherein, in said lowest level quantization and repeating multilevel quantization steps, all the representative vectors are sorted according to their statistical values selected from activity and dispersion value, and the vector search area is set within a certain region according to an activity or dispersion value of input vectors so as to reduce calculation time.

7. An image compression encoding method as claimed in any of the preceding claims, wherein, in said intra-vector allocation step, considering its activity, said encoding parameter is determined by a comparison result of the reference bits with the encoding result of the video signal of a preceding image.

8. An image compression encoding method as claimed in any of the preceding claims, wherein, in said intra-frame vector allocation step, the reference bits are satisfied by being differentially encoded according to weights and by image sections.

9. An image compression encoding method as claimed in any of the preceding claims, wherein a sync block is provided which comprises a sync signal for indicating the beginning and end of said sync block, an index signal for indicating a position within a frame, a first level quantization encoding code contained in an independent decodable code IDC area, an error correction code (ECC) for error-correcting the code loaded on the IDC area, a plurality of multilevel vector quantization encoding codes contained in a dependent decodable code (DDC) area, and an error correction code (ECC) for error-correcting the code loaded on the DDC area.

10. A compression encoder for partitioning a two-dimensional video signal into DCT blocks and encoding a transform coefficient of each DCT block at a predetermined compression rate, the encoder comprising:
DC encoding means (10) for scalar-quantizing the DC coefficient of said each DCT block;
classifier means (41) for classifying AC coefficients of said each DCT block into m classes;
lowest level quantization means (43) for comparing the classified AC coefficients of said each DCT block to f representative vectors from a code book set for each class classified by said classifier means (41), selecting a respective representative vector with the smallest error, and vector-quantizing the selected representative vector with a g-bit index of each representative vector;
a plurality of multilevel vector quantization means (46 and 49) for comparing the difference between the representative vector value from a preceding level vector quantization means (43, 46 and 49) and all the AC coefficients of said each DCT block, that is, errors produced from a preceding level encoding step, to h representative vectors from respective code books set for each classified class, selecting respective representative vectors with the smallest error and vector-quantizing the representative vectors with a g-bit index of each representative vector; and
intra-frame vector allocation means (60) for determining an encoding parameter whereby if the number of required bits for the preceding frame is smaller than that of the reference bits set for one frame, the value of the encoding parameter is controlled to require a larger number of bits in encoding a current image, and if the number of required bits for the preceding frame is larger than that of the reference bits set for one frame, the value of the encoding parameter is controlled to require a smaller number of bits in encoding a current image, and adaptively allocating vectors having an activity above the encoding parameter among the vectors of said plurality of multilevel vector quantization means (46 and 49).

## Patentansprüche

1. Kompression-Codierungsverfahren zum Unterteilen eines zweidimensionalen Videosignals in DCT-Blöcke und zum Codieren eines Transformationskoeffizienten jedes DCT-Blocks mit einer vorbestimmten Kompressionsrate, wobei das Verfahren umfaßt:
Skalarquantisieren des DC-Koeffizienten jedes DCT-Blocks durch n Bits:
einen Vektorquantisierungsschritt der niedrigsten Stufe zum Klassifizieren der AC-Koeffizienten jedes DCT-Blocks in m Klassen, zum Vergleichen der klassifizierten AC-Koeffizienten jedes DCT-Blocks mit f repräsentativen Vektoren aus einem für jede Klasse vorgegebenen Codebuch, zum Auswählen des entsprechenden repräsentativen Vektors mit dem kleinsten Fehler, zum Vektorquantisieren des ausgewählten repräsentativen Fehlers mit einem g-Bit-lndex jedes repräsentativen Vektors und zum Erzeugen von Codierungsbits (B) für jeden Block mit einer vorbestimmten Bitrate in Übereinstimmung mit der Gleichung B = n + log₂ + f*g;
einem wiederholten mehrstufigen Vektorquantisierungsschritt zum Vergleichen der Differenz zwischen dem Vektorquantisierungsergebnis aus einem vorhergehenden Quantisierungsschritt und allen AC-Koeffizienten jedes DCT-Blocks, d.h. des im vorhergehenden Quantisierungsschritt erzeugten Fehlers, mit h repräsentativen Vektoren aus entsprechenden, für jede klassifizierte Klasse vorgegebenen Codebüchern, zum Auswählen entsprechender repräsentativer Vektoren mit dem kleinsten Fehler und zum Vektorquantisieren der entsprechenden Vektoren mit einem g-Bit-lndex jedes repräsentativen Vektors, und
einen Intra-Frame-Vektorzuweisungsschritt zum Bestimmen eines Codierungsparameters, wobei der Wert des Codierungsparameters kontrolliert wird, so daß er eine größere Anzahl von Bits für das Codieren des aktuellen Bildes erfordert, wenn die Anzahl der erforderlichen Bits für den vorhergehenden Frame kleiner ist als die für einen Frame vorgegebene Anzahl der Referenzbits, und wobei der Wert des Codierungsparameters kontrolliert wird, so daß er eine kleinere Anzahl von Bits beim Codieren des aktuellen Bildes erfordert, wenn die Anzahl der erforderlichen Bits für den vorhergehenden Frame größer ist als die für einen Frame vorgegebene Anzahl der Referenzbits, sowie zum adaptiven Zuweisen von Vektoren mit einer Aktivität über dem Codierungsparameter aus den Vektoren, die aus dem wiederholten mehrstufigen Vektorquantisierungsschritt ausgegeben werden.

2. Bildkompression-Codierungsverfahren nach Anspruch 1, wobei bei der Klassifikation, die einen Teil oder alle der horizontalen AC-Koeffizienten, welche einen ersten AC-Koeffizienten enthalten, sowie der vertikalen AC-Koeffizienten, welche einen zweiten AC-Koeffizienten enthalten, verwendet, vorzugsweise die Kantenrichtung in Übereinstimmung mit dem kleinsten Wert des Quadrats des Werts festgestellt wird, wobei die AC-Koeffizienten von den repräsentativen Werten für vorgegebene Referenzklassen subtrahiert sind, wobei jeder DCT-Block in Übereinstimmung mit den Feststellungsergebnissen klassifiziert wird.

3. Bildkompression-Codierungsverfahren nach Anspruch 1 oder 2, wobei die Vektoren in den Schritten zur Quantisierung auf der niedrigsten Stufe und zur wiederholten mehrstufigen Quantisierung vorzugsweise durch ein Sampling mit gleichen Intervallen unterteilt werden.

4. Bildkompression-Codierungsverfahren nach Anspruch 3, wobei die Vektoren in dem Schritt zur Vektorquantisierung auf der niedrigsten Stufe vorzugsweise durch drei gleiche Intervall-Samplings unterteilt werden und wobei die Vektoren bei dem Schritt zum wiederholten mehrstufigen Quantisieren durch neun gleiche Intervall-Samplings unterteilt werden.

5. Bildkompression-Codierungsverfahren nach wenigstens einem der vorstehenden Ansprüche, wobei in dem Schritt zum Vektorquantisieren auf der niedrigsten Stufe die Variablen n, m, p und g jeweils 8, 8, 3 und 7 Bit umfassen, so daß die Gesamtanzahl der Bits für jeden Block gleich 32 ist.

6. Bildkompression-Codierungsverfahren nach wenigstens einem der vorstehenden Ansprüche, wobei alle repräsentativen Vektoren in den Schritten zur Quantisierung auf der niedrigsten Stufe und zur wiederholten mehrstufigen Quantisierung in Übereinstimmung mit ihren statistischen Werten, die aus der Aktivität und dem Dispersionswert ausgewählt werden, sortiert werden und wobei der Vektorsuchbereich innerhalb eines bestimmten Bereiches in Übereinstimmung mit der Aktivität oder dem Dispersionswert der Eingabevektoren vorgegeben wird, um die Berechnungszeit zu reduzieren.

7. Bildkompression-Codierungsverfahren nach wenigstens einem der vorstehenden Ansprüche, wobei der Codierungsparameter in dem Schritt zur Intra-Frame-Vektorzuweisung vorzugsweise unter Berücksichtigung seiner Aktivität durch ein Ergebnis des Vergleichs der Referenzbits mit dem Codierungsergebnis des Videosignals eines vorhergehenden Bildes bestimmt wird.

8. Bildkompression-Codierungsverfahren nach wenigstens einem der vorstehenden Ansprüche, wobei die Referenzbits in dem Schritt zur Intra-Frame-Vektorzuweisung vorzugsweise erfüllt werden, indem sie in Übereinstimmung mit Gewichtungen und Bildabschnitten unterschiedlich codiert werden.

9. Bildkompression-Codierungsverfahren nach wenigstens einem der vorstehenden Ansprüche, wobei ein Sync-Block vorgesehen ist, welcher umfaßt: ein Sync-Signal, das den Beginn und das Ende des Sync-Blocks angibt, ein Indexsignal, das eine Position in einem Frame angibt, einen Quantisierung-Codierungscode der ersten Stufe, der in einem unabhängig zu decodierenden Codebereich (IDC-Bereich) enthalten ist, einen Fehlerkorrekturcode (ECC) zur Fehlerkorrektur des in den IDC-Bereich geladenen Codes, eine Vielzahl von mehrstufigen Vektorquantisierungs-Codierungscodes, die in einem abhängig zu decodierenden Codebereich (DDC-Bereich) enthalten sind, sowie einen Fehlerkorrekturcode (ECC) zur Fehlerkorrektur des in den DDC-Bereich geladenen Codes.

10. Kompressioncodierer zum Unterteilen eines zweidimensionalen Videosignals in DCT-Blöcke und zum Codieren eines Transformationskoeffizienten jedes DCT-Blocks mit einer vorbestimmten Kompressionsrate, wobei der Codierer umfaßt:
eine DC-Codierungseinrichtung (10) zum Skalar-Quantisieren des DC-Koeffizienten jedes DCT-Blocks,
eine Klassifizierungseinrichtung (41) zum Klassifizieren der AC-Koeffizienten jedes DCT-Blocks in m Klassen,
eine Quantisierungseinrichtung (43) der niedrigsten Stufe zum Vergleichen der durch die Klassifizierungseinrichtung (41) klassifizierten AC-Koeffizienten jedes DCT-Blocks mit f repräsentativen Vektoren aus einem für jede Klasse vorgegebenen Codebuch, zum Auswählen des entsprechenden repräsentativen Vektors mit dem kleinsten Fehler und zum Vektor-Quantisieren des ausgewählten repräsentativen Vektors mit einem g-Bit-lndex jedes repräsentativen Vektors,
eine Vielzahl von mehrstufigen Vektorquantisierungseinrichtungen (46 und 49) zum Vergleichen der Differenz zwischen dem repräsentativen Vektorwert aus einer Vektorquantisierungseinrichtung (43, 46 und 49) der vorhergehenden Stufe und allen AC-Koeffizienten jedes DCT-Blocks, d.h. des in einem Codierungsschritt der vorhergehenden Stufe erzeugten Fehlers, mit h repräsentativen Vektoren aus entsprechenden für jede Klasse vorgegebenen Codebüchern, zum Auswählen von entsprechenden repräsentativen Vektoren mit dem kleinsten Fehler und zum Vektorquantisieren der repräsentiven Vektoren mit einem g-Bit-lndex jedes repräsentativen Vektors, und
eine Intra-Frame-Vektorzuweisungseinrichtung (60) zum Bestimmen eines Codierungsparameters, wobei der Wert des Codierungsparameters kontrolliert wird, so daß er eine größere Anzahl von Bits für das Codieren des aktuellen Bildes erfordert, wenn die Anzahl der erforderlichen Bits für den vorhergehenden Frame kleiner ist als die für einen Frame vorgegebene Anzahl von Referenzbits, und wobei der Wert des Codierungsparameters kontrolliert wird, so daß er eine kleinere Anzahl von Bits beim Codieren des aktuellen Bildes erfordert, wenn die Anzahl der erforderlichen Bits für den vorhergehenden Frame größer ist als die für einen Frame vorgegebene Anzahl von Referenzbits, sowie zum adaptiven Zuweisen von Vektoren mit einer Aktivität über dem Codierungsparameter aus den Vektoren, die aus der wiederholten mehrstufigen Vektorquantisierungseinrichtung (46 und 49) ausgegeben werden.

## Revendications

1. Procédé de codage de compression pour diviser un signal vidéo bidimensionnel en des blocs DCT et coder un coefficient de transformée de chaque bloc DCT avec un taux de compression prédéterminé, ledit procédé comprenant:
une quantification scalaire du coefficient de composante continue de chaque bloc DCT sur n bits;
une étape de quantification de vecteur de niveau le plus bas pour classer des coefficients de composante alternative de chaque bloc DCT en m classes, comparer les coefficients de composante alternative classifiés de chaque bloc DCT pour f vecteurs représentatifs provenant d'un fichier d'enregistrement de code pour chaque classe, sélectionner un vecteur représentatif respectif avec l'erreur la plus faible, quantifier vectoriellement l'erreur représentative sélectionnée, avec un index de g bits de chaque vecteur représentatif, et produire un certain nombre de bits de codage (B) pour tous les blocs avec un débit binaire prédéterminé en fonction de l'équation B = n + log₂m + f.g;
une étape de quantification vectorielle multiniveaux répétitive pour comparer la différence entre le résultat de quantification vectorielle d'une étape de quantification précédente et l'ensemble des coefficients de composante alternative de chacun desdits blocs DCT, c'est-à-dire, les erreurs produites dans l'étape de quantification précédente, à h vecteurs représentatifs provenant de fichiers d'enregistrement de code respectifs établis pour chaque classe classifiée, sélectionner des vecteurs représentatifs respectifs avec l'erreur la plus faible et quantifier vectoriellement les vecteurs représentatifs avec un index de g bits de chaque vecteur représentatif; et
une étape d'affectation de vecteur intra-trame pour déterminer un paramètre de codage de façon que si le nombre de bits requis pour la trame précédente est inférieur à celui des bits de référence établis pour une trame, la valeur du paramètre de codage est commandée pour requérir un nombre de bits supérieur dans le codage d'une image en cours, et si le nombre de bits requis pour la trame précédente est supérieur à celui des bits de référence établis pour une trame, la valeur du paramètre de codage est commandée pour requérir un nombre de bits inférieur dans le codage d'une image en cours et affecter de manière adaptative des vecteurs ayant une activité supérieure au paramètre de codage parmi les vecteurs délivrés par ladite étape de quantification vectorielle multiniveaux répétitive.

2. Procédé de codage de compression d'image selon la revendication 1, dans lequel, dans ladite classification utilisant une partie ou l'ensemble des coefficients de composante alternative parmi des coefficients de composante alternative horizontaux incluant un premier coefficient de composante alternative et des coefficients de composante alternative verticaux incluant un second coefficient de composante alternative selon une séquence de balayage en zigzag de chacun desdits blocs DCT, une direction de bord est détectée en fonction de la valeur la plus faible du carré de la valeur dans laquelle les coefficients de composante alternative sont soustraits aux valeurs représentatives pour des classes de référence pré-établies, et en fonction des résultats détectés, chaque bloc DCT est classifié.

3. Procédé de codage de compression d'image selon la revendication 1 ou 2, dans lequel, dans lesdites étapes de quantification de niveau le plus bas et de quantification multiniveaux répétitive, des vecteurs sont divisés par un échantillonnage avec des intervalles égaux.

4. Procédé de codage de compression d'image selon la revendication 3, dans lequel, dans ladite étape de quantification vectorielle de niveau le plus bas, des vecteurs sont divisés par trois échantillonnages avec intervalles égaux, et dans ladite étape de quantification multiniveaux répétitive, des vecteurs sont divisés par neuf échantillonnages avec intervalles égaux.

5. Procédé de codage de compression d'image selon l'une quelconque des revendications précédentes, dans lequel, dans ladite étape de quantification vectorielle de niveau le plus faible, des variables n, m, p, et g ont 8, 8, 3, et 7 bits, respectivement, de façon que le nombre global de bits est de 32 pour tous les blocs.

6. Procédé de codage de compression d'image selon l'une quelconque des revendications précédentes, dans lequel, dans lesdites étapes de quantification de niveau le plus bas et de quantification multiniveaux répétitive, tous les vecteurs représentatifs sont triés en fonction de leurs valeurs statistiques sélectionnées par rapport à une activité et une valeur de dispersion, et la zone de recherche de vecteur est définie à l'intérieur d'une certaine région en fonction d'une activité ou d'une valeur de dispersion de vecteurs d'entrée de façon à réduire un temps de calcul.

7. Procédé de codage de compression d'image selon l'une quelconque des revendications précédentes, dans lequel, dans ladite étape d'affectation de vecteur intra-trame, en considérant son activité, ledit paramètre de codage est déterminé par un résultat de comparaison des bits de référence avec le résultat de codage du signal vidéo d'une image précédente.

8. Procédé de codage de compression d'image selon l'une quelconque des revendications précédentes, dans lequel, dans ladite étape d'affectation de vecteur d'intra-trame, les bits de référence sont satisfaits en étant codés différentiellement selon des poids et par des sections d'image.

9. Procédé de codage de compression d'image selon l'une quelconque des revendications précédentes, dans lequel un bloc de synchronisation est prévu et celui-ci comprend un signal de synchronisation pour indiquer le début et la fin dudit bloc de synchronisation, un signal d'index pour indiquer une position à l'intérieur d'une trame, un code de codage de quantification de premier niveau contenu dans une zone IDC de code décodable indépendant, un code de correction d'erreur (ECC) pour corriger des erreurs du code chargé dans la zone IDC, une pluralité de codes de codage de quantification vectorielle multiniveaux contenus dans une zone de code décodable dépendant (DDC), et un code de correction d'erreur (ECC) pour corriger des erreurs du code chargé dans la zone DDC.

10. Codeur à compression pour diviser un signal vidéo bidimensionnel en des blocs DCT et coder un coefficient de transformée de chaque bloc DCT avec un taux de compression prédéterminé, le codeur comprenant:
des moyens de codage de composante continue (10) pour une quantification scalaire du coefficient de composante continue de chacun desdits blocs DCT;
des moyens de classification (41) pour classer des coefficients de composante alternative de chacun desdits blocs DCT en m classes;
des moyens de quantification de niveau le plus bas (43) pour comparer les coefficients de composante alternative classifiés de chacun desdits blocs DCT pour f vecteurs représentatifs d'un fichier d'enregistrement de code établi pour chaque classe classifiée par lesdits moyens de classification (41), sélectionner un vecteur représentatif respectif avec l'erreur la plus faible, et quantifier vectoriellement le vecteur représentatif sélectionné avec un index de g bits de chaque vecteur représentatif;
une pluralité de moyens de quantification vectorielle multiniveaux (46 et 49) pour comparer la différence entre la valeur de vecteur représentative provenant d'un moyen de quantification vectorielle de niveau précédent (43, 46 et 49) et l'ensemble des coefficients de composante alternative de chacun desdits blocs DCT, c'est-à-dire, les erreurs produites dans une étape de codage de niveau précédent, à h vecteurs représentatifs provenant de fichiers d'enregistrement de code respectifs établis pour chaque classe classifiée, sélectionner des vecteurs représentatifs respectifs avec l'erreur la plus faible et quantifier vectoriellement les vecteurs représentatifs avec un index de g bits de chaque vecteur représentatif; et
des moyens d'affectation de vecteur d'intra-trame (60) pour déterminer un paramètre de codage de façon que si le nombre de bits requis pour la trame précédente est inférieur à celui des bits de référence établis pour une trame, la valeur du paramètre de codage est commandée de façon à requérir un nombre de bits inférieur dans le codage d'une image en cours, et si le nombre de bits requis pour la trame précédente est supérieur à celui des bits de référence établis pour une trame, la valeur du paramètre de codage est commandée de façon à requérir un nombre de bits inférieur dans le codage d'une image en cours, et affecter de manière adaptative des vecteurs ayant une activité supérieure au paramètre de codage parmi les vecteurs de ladite pluralité de moyens de quantification vectorielle multiniveaux (46 et 49).
